# EUROPEAN PATENT SPECIFICATION

(11) **EP 4 048 045 B1**
(45) Date of publication and mention of the grant of the patent: **17.09.2025**
(21) Application number: 19949177.0
(22) Date of filing: 18.10.2019
(51) Int. Cl.: H05K 13/08

(54) **COMPONENT MOUNTING MACHINE**
KOMPONENTENMONTAGEMASCHINE
MACHINE DE MONTAGE DE COMPOSANT

(43) Date of publication of application: 24.08.2022
(73) Proprietor: Fuji Corporation, Chiryu-shi, Aichi 472-8686 (JP)
(72) Inventor: SAKURAYAMA, Takeshi, Chiryu-shi, Aichi 472-8686 (JP)
(74) Representative: Grünecker Patent- und Rechtsanwälte PartG mbB
(86) International application number: PCT/JP2019/041047
(87) International publication number: WO 2021/075042

(56) References cited:
- EP-A1- 2 978 296
- WO-A1-2014/136211
- JP-A- 2003 234 598
- JP-A- 2011 014 946
- JP-A- H07 326 895
- JP-A- H08 148 896
- JP-B2- 4 689 457

## Description

### Technical Field

The present disclosure relates to a component mounting machine that measures a mounting position of an electronic component mounted on a circuit base material to determine whether the mounting position is good or bad.

### Background Art

Patent Literature 1 discloses an electronic component mounting machine including an inspection device for inspecting whether a component type or an attaching position of an electronic component mounted on a printed circuit board is good or bad.

In the electronic component mounting machine, an abnormality in the type of the mounted electronic component and the position of the mounted component is detected by comparing an image of the printed circuit board imaged before the mounting of the electronic component with an image of the printed circuit board imaged after the mounting of the electronic component. Then, when the abnormality is detected in the mounting, as a content of the mounting abnormality, in a case where the electronic component has not fallen to another location on the printed circuit board, a new electronic component is supplied to perform the mounting on the printed circuit board surface, or the location of the mounting abnormality is notified to the operator. Meanwhile, when the electronic component is found elsewhere on the printed circuit board as the content of the mounting abnormality, the location of the dropped electronic component is notified to the operator.
EP 2978296 A1 relates to correcting mounting positions in component mounters. A mark on the board is detected, a mark on the component held by the suction nozzle is detected and a mark on the component mounter is detected. This makes it possible to detect the relative position between the component and the mounting head and correcting the mounting position of the mounting head based thereon and on the relative position of the mounting head and the board.

### Patent Literature

Patent Literature 1: JP-A-2006-319332

### Summary of the Invention

### Technical Problem

However, in the electronic component mounting machine described in Patent Literature 1, although the abnormality in the component type or the attaching position of the electronic component mounted on the printed circuit board can be detected, since the detection result is not reflected in the mounting of the next electronic component, the same abnormality may occur again.

Accordingly, an object of the present disclosure is to provide a component mounting machine capable of reflecting a result of measuring a mounting position of an electronic component mounted on a circuit base material in mounting of a next electronic component.
The invention is defined by the features of the independent claims. Any reference to inventions or embodiments not falling within the scope of the independent claims are to be interpreted as examples useful for understanding the invention.

### Solution to Problem

According to an aspect of the present disclosure, there is provided a component mounting machine according to claim 1.

### Advantageous Effect of the Invention

According to the present disclosure, it is possible to reflect a result of measuring a mounting position of an electronic component mounted on a circuit base material in mounting of the next electronic component.

### Brief Description of Drawings

Fig. 1 is a perspective view illustrating a schematic configuration of a component mounting machine according to an embodiment of the present disclosure.
Fig. 2 is a block diagram illustrating a control device included in the component mounting machine in Fig. 1.
Fig. 3 is a diagram illustrating an example of transition of a deviation amount of an electronic component when mounting of the electronic component on a circuit base material is repeated.
Fig. 4 is a flowchart illustrating a procedure of a mounting inspection process executed by a controller included in the control device in Fig. 2.

### Description of Embodiments

Hereinafter, embodiments of the present disclosure will be described in detail with reference to the accompanying drawings.

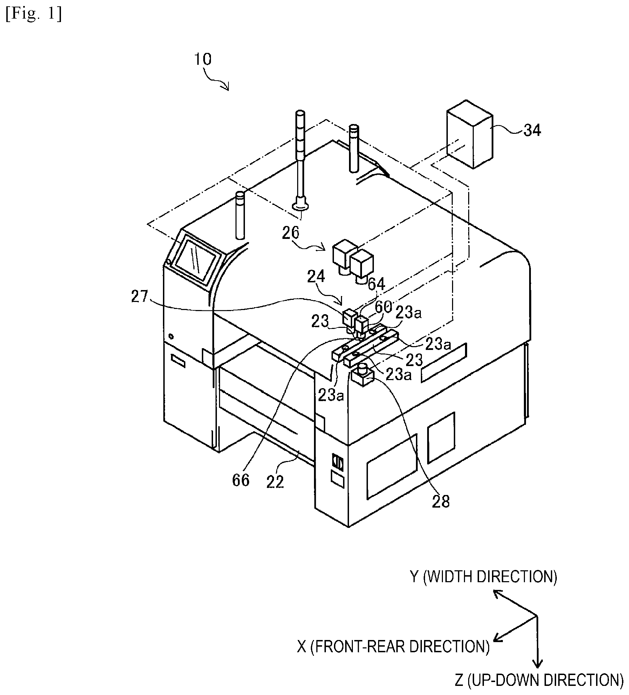

Fig. 1 illustrates a schematic configuration of component mounting machine 10 according to an embodiment of the present disclosure. It should be noted that when referring to a direction in Fig. 1, a direction of an arrow illustrated in the drawing is used.

Component mounting machine 10 includes base material conveyance/holding device 22 which conveys and fixes a circuit base material (not illustrated) to a predetermined position, ceiling camera 26 which can capture, in the field of view thereof, the entirety of the circuit base material fixed at the predetermined position by base material conveyance/holding device 22, component mounting device 24 and mark camera 27 having work head 60 provided on a moving platform (not illustrated) supported so as to be movable in an X-direction and a Y-direction with respect to base material conveyance/holding device 22, part camera 28 which is fixed to base material conveyance/holding device 22, and control device 34 which controls imaging by ceiling camera 26, mounting by component mounting device 24, and the like.

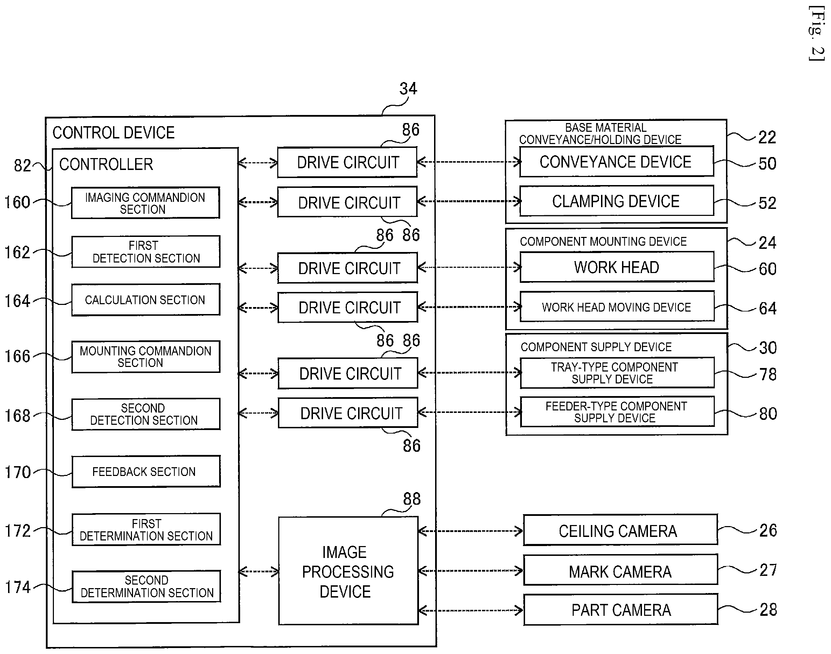

Base material conveyance/holding device 22 includes conveyance device 50 (refer to Fig. 2) which conveys a circuit base material to a predetermined position, that is, a predetermined mounting position where the electronic component is disposed, and clamping device 52 (refer to Fig. 2) which fixes the conveyed circuit base material at the mounting position. For example, conveyance device 50 is configured as a device for conveying the circuit base material by a belt conveyor, and includes a guide member (not illustrated) provided on each of pair of conveyor rails 23, a conveyor belt (not illustrated) provided on each of pair of conveyor rails 23, and a belt revolving device (not illustrated) for revolving and driving the conveyor belt. For example, clamping device 52 includes a support section (not illustrated) which supports the circuit base material from below, and a clamp section (not illustrated) which clamps an edge portion of the circuit base material. Examples of the circuit base material include a circuit board, a base material having a three-dimensional structure, or the like, and examples of the circuit board include a printed wiring board, a printed circuit board, or the like.

Two cameras serving as ceiling cameras 26 are disposed in parallel at a center of a ceiling portion of component mounting machine 10, and a predetermined rectangular region including the circuit base material fixed at a predetermined position is imaged by ceiling camera 26 from above. The imaged rectangular region is divided into two sections by the center lines of a pair of facing sides, and each of the divided sections corresponds to the field of view of one camera. As a result, the entire rectangular region including the circuit base material can be imaged by two cameras at once. The imaging timing of ceiling camera 26 is controlled by control device 34.

An X-direction beam (not illustrated) is provided above base material conveyance/holding device 22, and a Y-direction moving platform (not illustrated) is provided in the X-direction beam so as to be movable in the X-direction. Component mounting device 24 including work head 60 and mark camera 27 are held on the Y-direction moving platform so as to be movable in the Y-direction. An optical axis of mark camera 27 is parallel to a Z direction perpendicular to the X-direction and the Y-direction. The X-direction beam and the Y-direction moving platform are each controlled by a servo motor (not illustrated) via a ball screw, and the operation of the servo motor is controlled by control device 34. Mark camera 27 is a camera provided on the circuit base material to image a base material mark described later.

Component mounting device 24 includes work head moving device 64 which is attached to a Y-direction moving platform, work head 60 which is guided and supported by work head moving device 64 so as to be movable up and down in the Z direction perpendicular to the X-direction and the Y-direction while being controlled to move up and down by a servo motor, and suction nozzle 66 which protrudes downward from work head 60. Suction nozzle 66 is formed in a cylindrical shape, and suction nozzle 66 is configured to pick up and hold the electronic component at a lower end thereof. A mounting timing by component mounting device 24 is controlled by control device 34.

Component supply device 30 (refer to Fig. 2) is provided on one end side of component mounting machine 10. Part camera 28 having an optical axis parallel to the Z direction is provided on base material conveyance/holding device 22 between base material conveyance/holding device 22 and component supply device 30. Part camera 28 is a camera for imaging the electronic component.

Component supply device 30 includes tray-type component supply device 78 (refer to Fig. 2) and feeder-type component supply device 80 (refer to Fig. 2). Tray-type component supply device 78 is a device which supplies the component in a state of being placed on the tray. Feeder-type component supply device 80 is a device which supplies the component by a tape feeder and a stick feeder (not illustrated).

As illustrated in Fig. 2, control device 34 includes controller 82, multiple drive circuits 86, and image processing device 88. Multiple drive circuits 86 are connected to conveyance device 50, clamping device 52, work head 60, work head moving device 64, tray-type component supply device 78, and feeder-type component supply device 80. Controller 82 includes a Central Processing Unit (CPU), a Read Only Memory (ROM), a Random Access Memory (RAM), and the like, is mainly constituted by a computer, and is connected to multiple drive circuits 86. As a result, the operations of base material conveyance/holding device 22, component mounting device 24, component supply device 30, and the like are controlled by controller 82. Controller 82 is also connected to image processing device 88. Image processing device 88 is configured to process imaging data obtained by ceiling camera 26, mark camera 27, and part camera 28, and controller 82 acquires various types of information from the imaging data.

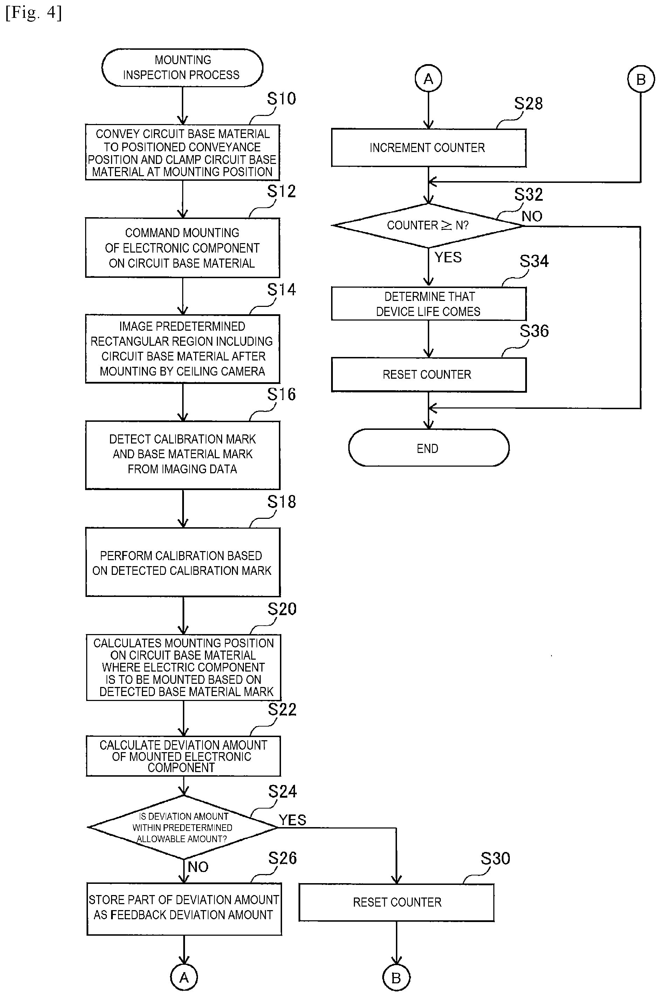

An inspection process of the electronic component mounted on the circuit base material using component mounting machine 10 configured as described above will be described below with reference to the flowchart in Fig. 4. Hereinafter, in descriptions of the procedures of each process, a step is denoted by "S".

First, controller 82 controls conveyance device 50 to convey the circuit base material to a positioned conveyance position, so that the circuit base material is supported by the support section. Controller 82 controls clamping device 52 to clamp and fix the supported circuit base material by the clamp section (S10).

Next, controller 82 commands component mounting device 24 to mount the electronic component on the fixed circuit base material (S12). In the mounting, a position of the base material mark (not illustrated) provided on the circuit base material is detected by mark camera 27, a positional correction is performed based on the position of the base material mark, and a coordinate position to be mounted is calculated.

In the present embodiment, multiple base material marks are provided on the circuit base material, and two or more base material marks to be used as a reference for each electronic component and a mounting position having the base material mark as a reference are determined in advance. For example, the mounting position is determined to be a position separated from one base material mark in the direction of another base material mark by 1/predetermined number of distances between the two base material marks. Accordingly, two base material marks corresponding to the electronic component which is a mounting target are detected from the imaging data, the distance between the two base material marks is calculated, and the position separated from one base material mark in the direction of another base material mark by 1/predetermined number of the calculated distance is set as the mounting position. It should be noted that when an effective feedback deviation amount is stored in a feedback deviation amount storage region (described later) in S26, the mounting position is determined by correcting the deviation amount.

Then, with respect to the electronic component picked up to a tip end of suction nozzle 66, misalignment of the electronic component with respect to the center line of suction nozzle 66 is detected by part camera 28, amounts of movement of suction nozzle 66 in the X-direction and the Y-direction are corrected, and the electronic component is mounted at the coordinate positions on the circuit base material.

Next, controller 82 commands ceiling camera 26 to perform the imaging. In response to this, ceiling camera 26 images a predetermined rectangular region including the circuit base material after the mounting (S14). Since ceiling camera 26 includes two cameras as described above, the imaging is simultaneously performed by the two cameras. The reason why the imaging is performed by the two cameras in this manner is that, in the present embodiment, since ceiling camera 26 is installed above the circuit base material at a distance of, for example, 500 mm or more, it is difficult to improve resolution with respect to a subject by one camera. However, as long as the necessary resolution can be obtained, one camera may be used, or as long as the necessary resolution is not obtained by two cameras, three or more cameras may be used.

The "predetermined rectangular region including the circuit base material" which is an imaging region is a rectangular region including the clamped circuit base material and the pair of conveyor rails 23 therearound. As illustrated in Fig. 1, two calibration marks 23a are provided on each conveyor rail 23. Two calibration marks 23a on each conveyor rail 23 are provided at a predetermined distance, for example, 300 mm apart from each other on a thin plate of a material of which thermal expansion is difficult to occur, for example, quartz glass. In the present embodiment, since conveyor rail 23 is made of steel, a thin plate of quartz glass is fixed on conveyor rail 23. As described above, since calibration mark 23a is hardly affected by thermal expansion caused by heat generated when component mounting machine 10 mounts the electronic component, the distance between calibration marks 23a is substantially unchanged at 300 mm in the present embodiment. Accordingly, by detecting calibration marks 23a on each conveyor rail 23 from the imaging data of the rectangular region and calculating the distance between calibration marks 23a, the calculated distance actually corresponds to 300 mm. Controller 82 performs calibration on the imaging data based on the invariant distance, and calculates the mounting position on the circuit base material on which the electronic component is to be mounted based on the imaging data after the calibration.

It should be noted that the mounting position is calculated based on the base material mark included in the imaging data after the calibration, as described above.

As described above, the images of both calibration mark 23a and the base material mark are included in the imaging data. That is, the calibration and the calculation of the mounting position are performed using the same imaging data. This is because, since both calibration mark 23a and base material mark are shaken by vibration generated when component mounting machine 10 mounts the electronic component, by performing the calibration based on calibration mark 23a and calculating the mounting position based on the base material mark detected from the imaging data after the calibration, it is possible to cancel a shake component mixed in the imaging data.

Next, controller 82 detects calibration mark 23a and the base material mark from the imaging data (S16).

Next, controller 82 performs the calibration on the imaging data based on calibration mark 23a detected in S16 (S18). Specifically, controller 82 first calculates the distance between two calibration marks 23a on each conveyor rail 23. Since the calculated distances are the same for each conveyor rail 23, when both distances are different from each other, it means that ceiling camera 26 does not correctly image a predetermined rectangular region including the circuit base material. Accordingly, controller 82 corrects the imaging data so that both distances coincide with each other. In the present embodiment, the calibration of S16 is performed each time the mounting inspection process is executed, but the present invention is not limited to this, and may be performed at a predetermined timing. In addition, in addition to the calibration in S16, it is necessary to perform camera calibration of ceiling camera 26, that is, matrix correction (lens distortion correction).

Next, controller 82 calculates the mounting position as described above based on the base material mark detected in S16 (S20).

Controller 82 calculates a deviation amount of the mounted electronic component based on the imaging data acquired in S14 (S22). For example, the deviation amount is calculated by calculating the distance between the coordinate of the center point on the circuit base material to which the electronic component is mounted and the coordinate of the center point of the electronic component in the imaging data.

Next, controller 82 determines whether the calculated deviation amount is within a predetermined allowable amount (S24). In this determination, when it is determined that the calculated deviation amount is not within the predetermined allowable amount (S24: NO), controller 82 stores a part of the calculated deviation amount, for example, 1/2 of the calculated deviation amount in a region (hereinafter, referred to as a "feedback deviation amount storage region") secured in the RAM provided in controller 82 (S26). As described above, the reason why a part of the calculated deviation amount is set as the feedback deviation amount instead of the entire calculated deviation amount is because since a reading error by ceiling camera 26 is inevitably included in the imaging data used when calculating the deviation amount, when the entire calculated deviation amount is set as the feedback deviation amount, the reading error amount is also fed back, and thus, mounting accuracy may be reduced by the reading error amount.

Next, after incrementing the counter by "1" (S28), controller 82 advances the processing to S32. Here, the counter is a software counter secured in the RAM, and is used to determine whether the deviation amount of the mounted electronic component converges within a predetermined allowable amount.

Meanwhile, when the calculated deviation amount is within the predetermined allowable amount in the determination of S24 (S24: YES), controller 82 resets the counter (S30), and then advances the processing to S32.

In S32, controller 82 determines whether the count value of the counter ≥ N. However, "N" is a predetermined integer value. In this determination, when it is determined that a count value of the counter ≥ N (S32: YES), controller 82 determines that component mounting machine 10 is now in its device life (S34), resets the counter (S36), and then terminates the mounting inspection process.

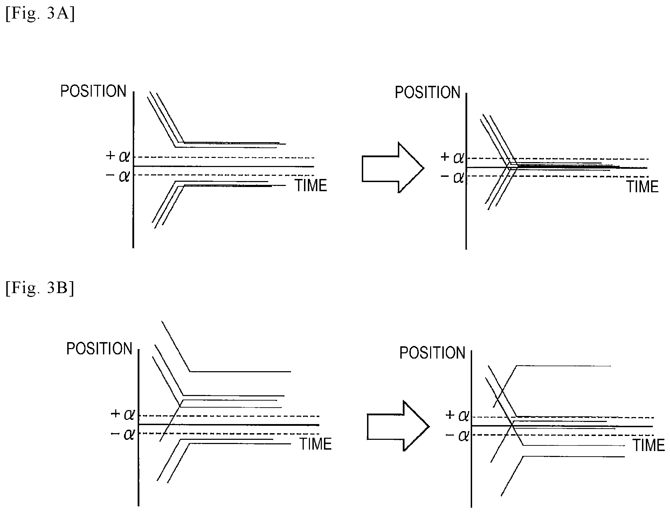

Fig. 3 illustrates an example of transition of the deviation amount of one electronic component when the electronic component is repeatedly mounted on the circuit base material. In Fig. 3, transition before an arrow represents transition before the feedback control of S12 is performed, and transition after the arrow represents transition after the feedback control of S12 is performed.

Then, Fig. 3(a) illustrates a state in which the deviation amount of the electronic component after the mounting converges within the predetermined allowable amount (in the illustrated example, ±α) when the feedback control of S12 is performed. Meanwhile Fig. 3(b) illustrates a state in which the deviation amount of the electronic component after the mounting does not converge within a predetermined allowable amount (in the illustrated example, ±α) even when the feedback control of S12 is performed.

Even when rattling occurs due to a long-term use, component mounting machine 10 has a repeatability such that the deviation amount of the electronic component after the mounting does not fall within a predetermined allowable amount, as in the transition before the arrow in Fig. 3(a), but falls within the predetermined range as long as the same operation is performed. When the feedback control of S12 is performed on component mounting machine 10 having the repeatability, as in the transition after the arrow in Fig. 3(a), the deviation amount of the electronic component after the mounting falls within the predetermined allowable amount, and thus, the mounting accuracy at the time of new mounting can be maintained even in a device with reduced mounting accuracy.

Meanwhile, in a case where component mounting machine 10 does not have the repeatability as in the transition before the arrow in Fig. 3(b), even when the feedback control of S12 is performed, the deviation amount of the electronic component after the mounting does not fall within the predetermined allowable amount as in the transition after the arrow in Fig. 3(b). Accordingly, in the example of Fig. 3(b), it is determined that the count value of the counter ≥ N in S32, and it is determined in S34 such that the device life of component mounting machine 10 has come.

Meanwhile, when it is determined that the count value of the counter < N in the determination of S32 (S32: NO), controller 82 terminates the mounting inspection process.

As described above, component mounting machine 10 of the present embodiment includes base material conveyance/holding device 22 configured to convey the circuit base material and hold the circuit base material at the predetermined position, component mounting device 24 configured to mount the electronic component supplied by component supply device 30 on the circuit base material held at the predetermined position, ceiling camera 26 configured to capture, in a field of view of ceiling camera 26, an entirety of a predetermined region including the circuit base material held at the predetermined position, imaging command section 160 configured to command ceiling camera 26 to image the predetermined region, first detection section 162 configured to detect at least one calibration mark 23a provided on base material conveyance/holding device 22 and at least one base material mark provided on the circuit base material, based on imaging data imaged according to the command of imaging command section 160, calculation section 164 configured to calculate a position on the circuit base material where the electronic component is to be mounted, based on calibration mark 23a and the base material mark detected by first detection section 162, mounting command section 166 configured to command component mounting device 24 to mount the electronic component at the position on the circuit base material calculated by calculation section 164, second detection section 168 configured to detect the deviation amount between a position on the circuit base material where component mounting device 24 actually mounts the electronic component according to the command of mounting command section 166 and the position on the circuit base material calculated by calculation section 164, and feedback section 170 configured to feed back, as a correction value for correcting a position on the circuit base material to be calculated next by calculation section 164, a part of the deviation amount detected by second detection section 168.

As described above, in component mounting machine 10 of the present embodiment, it is possible to reflect the result of measuring the mounting position of the electronic component mounted on the circuit base material in the mounting of the next electronic component.

Incidentally, in the present embodiment, ceiling camera 26 is an example of an "imaging device". Calibration mark 23a is an example of a "device mark".

Ceiling camera 26 includes one or more cameras.

As a result, it is possible to improve resolution with respect to a subject.

Ceiling camera 26 is installed in a ceiling portion of component mounting machine 10.

As a result, the entire predetermined region including the circuit base material can be captured in the field of view.

In addition, base material conveyance/holding device 22 includes conveyor rail 23 for conveying the circuit base material, and calibration mark 23a is provided on conveyor rail 23.

As a result, since both calibration mark 23a and the base material mark are included in the predetermined region including the circuit base material, both calibration mark 23a and the base material mark are included in the imaging data. Then, since both calibration mark 23a and the base material mark are shaken by the vibration generated when component mounting machine 10 mounts the electronic component, by performing the calibration based on calibration mark 23a and calculating the mounting position based on the base material mark detected from the imaging data after the calibration, it is possible to cancel the shake component mixed in the imaging data.

In addition, component mounting machine 10 further includes first determination section 172 configured to determine whether the deviation amount converges within a predetermined range, and second determination section 174 configured to determine that there is an abnormality in component mounting machine 10 when it is determined that the deviation amount does not converge within the predetermined range by first determination section 172.

As a result, it is possible to self-determine the abnormality of component mounting machine 10.

Incidentally, the device life is an example of the "abnormality".

It should be noted that the present invention is not limited to the above embodiment, and various modifications can be made without departing from the scope of the appended claims.
(1) In the above embodiment, multiple calibration marks 23a and multiple base material marks are provided in order to specify the direction. Accordingly, as long as the direction can be specified by one mark, for example, by the shape, multiple marks need not be provided.
(2) In the above embodiment, 1/2 of the deviation amount of the mounted electronic component is adopted as the feedback deviation amount, but the present invention is not limited to this, and other values such as 1/4 and 1/6 may be employed. However, the entire deviation amount cannot be set as the feedback deviation amount. This is because, as described above, since the imaging data used when calculating the deviation amount inevitably includes the reading error by ceiling camera 26, the mounting accuracy is prevented from being reduced by the reading error.
(3) In the above embodiment, the mounting position of the electronic component on the circuit base material is calculated based on the base material mark detected from imaging data in S20, but the present invention is not limited to this, and may be calculated or determined based on a land detected from the imaging data.

### Reference Signs List

10: component mounting machine, 22: base material conveyance/holding device, 26: ceiling camera, 30: component supply device, 82: controller, 160: imaging command section, 162: first detection section, 164: calculation section, 166: mounting command section, 168: second detection section, 170: feedback section, 172: first determination section, 174: second determination section

## Claims

1. A component mounting machine (10) comprising:
a base material conveyance/holding device (22) configured to convey a circuit base material such as a circuit board and hold the circuit base material at a predetermined position;
a component mounting device (24) configured to mount an electronic component supplied by a component supply device on the circuit base material held at the predetermined position;
an imaging device (26) configured to capture, in a field of view of the imaging device (26), an entirety of a predetermined region including the circuit base material held at the predetermined position and a pair of conveyor rails therearound;
an imaging command section (160) configured to command the imaging device (26) to image the predetermined region;
a first detection section (162) configured to detect at least one device mark provided on the base material conveyance/holding device (22) and at least one base material mark provided on the circuit base material, based on imaging data imaged according to the command of the imaging command section (160);
a calculation section (164) configured to calculate a position on the circuit base material where the electronic component is to be mounted, based on the device mark and the base material mark detected by the first detection section (162);
a mounting command section (166) configured to command the component mounting device (24) to mount the electronic component at the position on the circuit base material calculated by the calculation section (164);
**characterized by** a second detection section (168) configured to detect, based on the imaging data, a deviation amount between a position on the circuit base material where the component mounting device (24) actually mounts the electronic component according to the command of the mounting command section (166) and the position on the circuit base material calculated by the calculation section (164); and
a feedback section (170) configured to feed back, as a correction value for correcting a position on the circuit base material to be calculated next by the calculation section (164), a part of the deviation amount detected by the second detection section (168).

2. The component mounting machine (10) according to claim 1, wherein the imaging device (26) includes one or more cameras.

3. The component mounting machine (10) according to claim 1 or 2, wherein the imaging device (26) is installed in a ceiling portion of the component mounting machine (10).

4. The component mounting machine (10) according to any one of claims 1 to 3, wherein the base material conveyance/holding device (22) includes a conveyor rail for conveying the circuit base material, and
the device mark is provided on the conveyor rail.

5. The component mounting machine (10) according to any one of claims 1 to 4, further comprising:
a first determination section configured to determine whether the deviation amount converges within a predetermined range; and
a second determination section configured to determine that there is an abnormality in the component mounting machine (10) when it is determined that the deviation amount does not converge within the predetermined range by the first determination section.

## Patentansprüche

1. Bauteilbestückungsmaschine (10), umfassend:
eine Basismaterial-Förder-/Haltevorrichtung (22), die so konfiguriert ist, dass sie ein Schaltungsbasismaterial, wie beispielsweise eine Leiterplatte, fördert und das Schaltungsbasismaterial an einer vorbestimmten Position hält;
eine Bauteilbestückungsvorrichtung (24), die so konfiguriert ist, dass sie ein von einer Bauteilzuführvorrichtung zugeführtes elektronisches Bauteil auf dem an der vorbestimmten Position gehaltenen Schaltungsbasismaterial bestückt;
eine Bildgebungsvorrichtung (26), die so konfiguriert ist, dass sie in einem Sichtfeld der Bildgebungsvorrichtung (26) einen vorbestimmten Bereich, der das an der vorbestimmten Position gehaltene Schaltungsbasismaterial und ein Paar um dieses herum angeordnete Förderschienen umfasst, vollständig erfasst;
einen Bildgebungsbefehlsabschnitt (160), der so konfiguriert ist, dass er der Bildgebungsvorrichtung (26) befiehlt, den vorbestimmten Bereich abzubilden;
einen ersten Erfassungsabschnitt (162), der so konfiguriert ist, dass er mindestens eine Vorrichtungsmarkierung, die auf der Basismaterial-Förder-/Haltevorrichtung (22) vorgesehen ist, und mindestens eine Basismaterialmarkierung, die auf dem Schaltungsbasismaterial vorgesehen ist, auf der Grundlage von Bilddaten erfasst, die gemäß dem Befehl des Bildgebungsbefehlsabschnitts (160) abgebildet wurden;
einen Berechnungsabschnitt (164), der so konfiguriert ist, dass er eine Position auf dem Schaltungsbasismaterial berechnet, an der das elektronische Bauteil angebracht werden soll, basierend auf der Vorrichtungsmarkierung und der Basismaterialmarkierung, die vom ersten Erfassungsabschnitt (162) erfasst wurden;
einen Anbringungsbefehlsabschnitt (166), der so konfiguriert ist, dass er die Bauteilbestückungsvorrichtung (24) anweist, das elektronische Bauteil an der vom Berechnungsabschnitt (164) berechneten Position auf dem Schaltungsbasismaterial anzubringen;
**gekennzeichnet durch**
einen zweiten Erfassungsabschnitt (168), der so konfiguriert ist, dass er auf der Grundlage der Bilddaten einen Abweichungsbetrag zwischen einer Position auf dem Schaltungsbasismaterial, an der die Bauteilbestückungsvorrichtung (24) das elektronische Bauteil gemäß dem Befehl des Anbringungsbefehlsabschnitts (166) tatsächlich befestigt, und der vom Berechnungsabschnitt (164) berechneten Position auf dem Schaltungsbasismaterial erfasst; und
einen Rückkopplungsabschnitt (170), der so konfiguriert ist, dass er einen Teil des vom zweiten Erfassungsabschnitt (168) erfassten Abweichungsbetrags als Korrekturwert zur Korrektur einer vom Berechnungsabschnitt (164) als nächstes zu berechnenden Position auf dem Schaltungsbasismaterial zurückkoppelt.

2. Bauteilbestückungsmaschine (10) nach Anspruch 1, wobei die Bildgebungsvorrichtung (26) eine oder mehrere Kameras umfasst.

3. Bauteilbestückungsmaschine (10) nach Anspruch 1 oder 2, wobei die Bildgebungsvorrichtung (26) in einem Deckenbereich der Bauteilbestückungsmaschine (10) installiert ist.

4. Bauteilbestückungsmaschine (10) nach einem der Ansprüche 1 bis 3, wobei die Basismaterial-Förder-/Haltevorrichtung (22) eine Förderschiene zum Fördern des Schaltungsbasismaterials umfasst und
die Vorrichtungsmarkierung auf der Förderschiene vorgesehen ist.

5. Bauteilbestückungsmaschine (10) nach einem der Ansprüche 1 bis 4, ferner umfassend:
einen ersten Bestimmungsabschnitt, der so konfiguriert ist, dass er bestimmt, ob der Abweichungsbetrag innerhalb eines vorbestimmten Bereichs konvergiert; und
einen zweiten Bestimmungsabschnitt, der so konfiguriert ist, dass er bestimmt, dass eine Anomalie in der Bauteilbestückungsmaschine (10) vorliegt, wenn durch den ersten Bestimmungsabschnitt bestimmt wird, dass der Abweichungsbetrag nicht innerhalb des vorbestimmten Bereichs konvergiert.

## Revendications

1. Machine de montage de composant (10) comprenant :
un dispositif de déplacement/maintien de matériau de base (22) configuré pour déplacer un matériau de base de circuit tel qu'une carte de circuit et pour maintenir le matériau de base de circuit au niveau d'une position prédéterminée ;
un dispositif de montage de composant (24) configuré pour monter un composant électronique qui est alimenté par un dispositif d'alimentation de composant sur le matériau de base de circuit qui est maintenu au niveau de la position prédéterminée ;
un dispositif imageur (26) configuré pour capturer, dans un champ de vision du dispositif imageur (26), la totalité d'une région prédéterminée qui inclut le matériau de base de circuit qui est maintenu au niveau de la position prédéterminée et une paire de rails de dispositif de transport au voisinage ;
une section de commande d'imagerie (160) configurée pour commander le dispositif imageur (26) pour qu'il image la région prédéterminée ;
une première section de détection (162) configurée pour détecter au moins un repère de dispositif qui est apposé sur le dispositif de déplacement/maintien de matériau de base (22) et au moins un repère de matériau de base qui est apposé sur le matériau de base de circuit, sur la base de données d'imagerie qui sont imagées conformément à la commande de la section de commande d'imagerie (160) ;
une section de calcul (164) configurée pour calculer une position sur le matériau de base de circuit au niveau de laquelle le composant électronique doit être monté, sur la base du repère de dispositif et du repère de matériau de base qui sont détectés par la première section de détection (162) ; et
une section de commande de montage (166) configurée pour commander le dispositif de montage de composant (24) afin de monter le composant électronique au niveau de la position, sur le matériau de base de circuit, qui est calculée par la section de calcul (164) ;
**caractérisée par** :
une seconde section de détection (168) configurée pour détecter, sur la base des données d'imagerie, une valeur de déviation entre une position sur le matériau de base de circuit au niveau de laquelle le dispositif de montage de composant (24) monte de fait le composant électronique conformément à la commande de la section de commande de montage (166) et la position sur le matériau de base de circuit qui est calculée par la section de calcul (164) ; et
une section de fourniture en retour d'information (170) configurée pour fournir en retour, en tant que valeur de correction pour corriger une position, sur le matériau de base de circuit, destinée à être calculée ensuite par la section de calcul (164), une partie de la valeur de déviation qui est détectée par la seconde section de détection (168).

2. Machine de montage de composant (10) selon la revendication 1, dans laquelle le dispositif imageur (26) inclut une ou plusieurs caméras.

3. Machine de montage de composant (10) selon la revendication 1 ou 2, dans laquelle le dispositif imageur (26) est installé dans une partie de plafond de la machine de montage de composant (10).

4. Machine de montage de composant (10) selon l'une quelconque des revendications 1 à 3, dans laquelle :
le dispositif de déplacement/maintien de matériau de base (22) inclut un rail de dispositif de transport pour transporter le matériau de base de circuit ; et
le repère de dispositif est apposé sur le rail de dispositif de transport.

5. Machine de montage de composant (10) selon l'une quelconque des revendications 1 à 4, comprenant en outre :
une première section de détermination configurée pour déterminer si la valeur de déviation converge ou non à l'intérieur d'une plage prédéterminée ; et
une seconde section de détermination configurée pour déterminer qu'il y a une anomalie dans la machine de montage de composant (10) lorsqu'il est déterminé, par la première section de détermination, que la valeur de déviation ne converge pas à l'intérieur de la plage prédéterminée.
